**Europäisches Patentamt**

(19) **European Patent Office**

**Office européen des brevets**

(11) Veröffentlichungsnummer: **0 137 951**
**B1**

(12) **EUROPÄISCHE PATENTSCHRIFT**

(45) Veröffentlichungstag der Patentschrift:
**25.11.87**

(21) Anmeldenummer: **84109645.6**

(22) Anmeldetag: **13.08.84**

(51) Int. Cl.⁴: **H 01 L 29/08,** H 01 L 29/52,
H 01 L 29/74

(54) Thyristor mit MIS-gesteuerten Emitterkurzschlüssen.

(30) Priorität: **19.08.83 DE 3330022**

(43) Veröffentlichungstag der Anmeldung:
**24.04.85 Patentblatt 85/17**

(45) Bekanntmachung des Hinweises auf die Patenterteilung:
**25.11.87 Patentblatt 87/48**

(84) Benannte Vertragsstaaten:
**CH DE FR GB IT LI SE**

(56) Entgegenhaltungen:
**EP-A-0 022 355**
**EP-A-0 030 274**
**EP-A-0 064 717**
**EP-A-0 065 174**
**EP-A-0 066 850**

(73) Patentinhaber: **Siemens Aktiengesellschaft Berlin und München, Wittelsbacherplatz 2, D-8000 München 2 (DE)**

(72) Erfinder: **Herberg, Helmut, Dr., Bruderhofstrasse 30a, D-8000 München 70 (DE)**

## Beschreibung

Die Erfindung bezieht sich auf einen Thyristor nach den Oberbegriffe der Patentanspruchs 1 und 2.

Derartige Thyristoren sind z.B. aus DE-A-29 45 366 A1 und DE-A-31 18 354 A1 bekannt. Bei diesen ist jeweils ein gemeinsamer Steuerspannungsanschluß vorgesehen, über den den MIS-Strukturen eine Gatespannung zugeführt wird. Für den Fall, daß ein solcher Thyristor Fehlerstellen aufweist, die z. B. aus Löchern oder Schwachstellen in Gateoxid bestehen, bricht die beim Zünden angelegte Gatespannung infolge des an den Fehlerstellen vorhandenen Kurzschlusses zusammen, was zur Folge hat, daß die steuerbaren Emitterkurzschlüsse ständig wirksam bleiben und der Thyristor nicht mehr gezündet werden kann. Die Fehlerstellendichte ist in allgemeinen so groß, daß insbesondere bei großflächigen Thyristoren eine Selektion der fehlerfreien Exemplare zu einer sehr geringen Ausbeute führen würde.

Der Erfindung liegt die Aufgabe zugrunde, einen Thyristor der eingangs genannten Art anzugeben, bei dem eine oder auch mehrere Fehlerstellen toleriert werden können, ohne daß er deswegen von einer Verwendung ausgeschlossen werden müßte. Das wird erfindungsgemäß durch eine Ausbildung desselben nach dem kennzeichnenden Teil des Patentanspruchs 1 erreicht.

Der mit der Erfindung erzielbare Vorteil besteht insbesondere darin, daß nur diejenigen Gruppen von Emitterzonen, in deren Bereichen die Fehlerstellen vorhanden sind, unwirksam geschaltet werden, während die übrigen Gruppen funktionstüchtig bleiben. Daher wird lediglich die Strombelastbarkeit des Thyristors wegen des Ausfallens einer oder mehrerer Emitterzonengruppen und der Beschränkung des stromführenden Querschnitts auf die übrigen Emitterzonen entsprechend der Anzahl und Anordnung der Fehlerstellen herabgesetzt, wobei der Thyristor aber trotz des Vorhandenseins dieser Fehlerstellen als solcher einsatzfähig bleibt.

Die Erfindung wird nachfolgend anhand der Zeichnung näher erläutert. Dabei zeigt:

Fig. 1 den Querschnitt eines herkömnlichen, mit steuerbaren Emitterkurzschlüssen versehenen Thyristors,

Fig. 2 den Querschnitt eines weiteren herkömnlichen Thyristors, dessen steuerbare Emitterkurzschlüsse alterniv zu Fig. 1 ausgebildet sind,

Fig. 3 einen erfindungsgemäß ausgebildeten Thyristor und

Fig. 4 eine strukturelle Einzelheit zu Fig. 3.

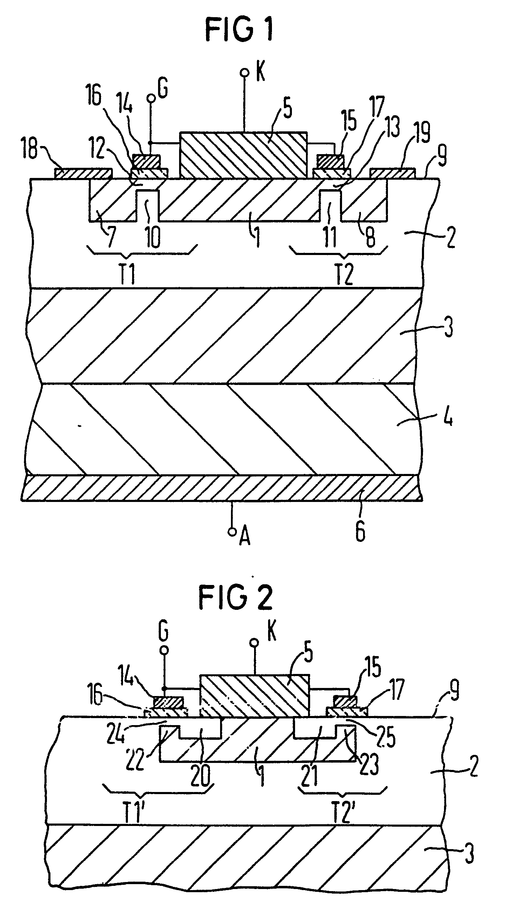

Der Thyristor nach Figur 1 besteht aus einem Körper aus dotiertem Halbleitermaterial, z. B. Si, der mehrere aufeinanderfolgende Schichten abwechselnder Leitfähigkeitstypen aufweist. 1 bezeichnet dabei eine n-Emitterzone, die in eine p-Basis 2 eingefügt ist. An diese schließt sich eine n-Basis 3 an, während die unterste Schicht 4 als p-Emitter bezeichnet wird. Die n-Emitterzone wird von einer Kathode bzw. einem Kathodenteil 5 aus elektrisch leitendem Material, z. B. Al, kontaktiert, die mit einem Anschluß K versehen ist, während der p-Emitter 4 von einer aus elektrisch leitenden Material, z. B. Al, bestehenden Anode 6 kontaktiert wird, die einen Anschluß A besitzt.

Zu beiden Seiten der n-Emitterzone sind n-leitende Halbleitergebiete 7 und 8 in die p-Basis 2 eingefügt, die sich bis zur Grenzfläche 9 des Halbleiterkörpers erstrecken. Die Teilgebiete 10 und 11 der p-Basis 2, die mit ihrer Breite den Abstand der Halbleitergebiete 7 und 8 von der n-Emitterzone 1 bestimmen, sind an der Grenzfläche 9 mit einer n-Dotierung versehen, so daß zwei n-leitende Kanäle 12 und 13 gebildet werden, die die Teile 1 und 7 bzw. 1 und 8 miteinander verbinden. Die Kanäle 12 und 13 können beispielsweise durch eine Implantation von Arsenionen erzeugt werden, wobei eine Dosis von $10^{13}/cm^2$ mit einer Energie von etwa 80 KeV implantiert wird. Die genannten Kanäle sind von Gateelektroden 14, 15 überdeckt, die von den Halbleiterkörper durch dünne elektrisch isolierende Schichten 16, 17, z. B. aus $SiO_2$, getrennt sind. Dabei bestehen die Gateelektroden 14, 15 aus elektrisch leitendem Material, z. B. hochdotiertem polykristallinem Silizium, und sind mit einem gemeinsamen Anschluß G verbunden. Leitende Belegungen 18, 19 überbrücken die pn-Übergänge zwischen der p-Basis 2 und den Halbleitergebieten 7 und 8 an den von den Teilgebieten 10, 11 abgewandten Seiten der letzteren.

Der linke Randbereich der n-Emitterzone 1 stellt das Draingebiet und das Halbleitergebiet 7 das Sourcegebiet eines MIS-Feldeffekttransistors des Verarmungstyps T1 dar, der ferner einen n-leitenden Kanal 12 besitzt, welcher von der Gateelektrode 14 überdeckt wird. In analoger Weise bildet der rechte Randbereich von 1 zusammen mit den Teilen 8, 13, 15 und 17 einen MIS-Feldeffekttransistor T2. Die n-Kanäle 12 und 13 sind bei spannungslosem Anschluß G vorhanden. Legt man dagegen an G eine hinreichend große negative Gatespannung an, so werden die Kanäle 12, 13 hochohmig bzw. unwirksan geschaltet.

T1 und T2 stellen somit Schalter dar, die in einem ersten Schaltzustand (spannungsloser Anschluß G) die n-Emitterzone 1 mit den Halbleitergebieten 7 und 8 und weiterhin über die Belegungen 18 und 19 mit der p-Basis 2 niederohmig verbinden. In einem zweiten Schaltzustand (negative Spannung an G) wird diese niederohmige Verbindung dann unterbrochen bzw. hochohmig geschaltet. T1 stellt also zusammen mit der leitenden Belegung 18 einen ersten und T2 zusammen mit der Belegung 19 einen zweiten steuerbaren Emitterkurzschluß dar.

Der Thyristor nach Fig. 1 ist mit einer Mehrzahl von vorzugsweise streifenförmig ausgebildeten n-Emitterzonen 1 versehen, die beispielsweise senkrecht zur Zeichenebene und zueinander parallel ausgerichtet sind. Die einzelnen Emitterzonen sind dabei mit zugeordneten Kathodenteilen 5 versehen, die untereinander leitend verbunden sind. Jede der n-Emitterzonen ist in der beschriebenen und dargestellten Weise mit randseitigen Emitterkurzschlüssen versehen, die ebenfalls streifenförnig ausgebildet und senkrecht zur Zeichenebene orientiert sind.

Im Betrieb bleibt der Gateanschluß G jeweils vor dem Zündzeitpunkt, d.h. in blockierten Zustand des Thyristors, von Spannungen freigeschaltet. Dabei sind die n-Emitterzonen 1 mit der p-Basis 2 niederohmig verbunden, was den Thyristor gegenüber unbeabsichtigten Zündvorgängen stabilisiert. Zum Zünden wird ihm über eine Zündelektrode ein Zündstromimpuls zugeführt. Gleichzeitig wird der Anschluß G für die Dauer des Zündvorgangs mit einem negativen Spannungsimpuls belegt, der die n-Kanäle 12, 13 usw. unwirksam schaltet, was die Zündempfindlichkeit wesentlich erhöht. Nach erfolgter Zündung fließt dann ein Laststrim eines bei A und K angeschlossenen Laststromkreises über den niederohmig geschalteten Thyristor. Die Abschaltung des Thyristors wird durch eine Abschaltung der zwischen A und K anliegenden Spannung oder bei einer anliegenden Wechselspannung durch den nächstfolgenden Nulldurchgang derselben erreicht.

Fig. 2 zeigt einen herkömmlichen Thyristor, der sich von Fig. 1 dadurch unterscheidet, daß seine steuerbaren Emitterkurzschlüsse in anderer Weise ausgebildet sind. Er weist Strukturteile auf, die bereits anhand von Fig. 1 beschrieben wurden und mit denselben Bezugszeichen wie dort versehen sind. Hierbei sind p-leitende Halbleitergebiete 20 und 21 in die Randgebiete der n-Emitterzone 1 so eingefügt, daß sie sich bis zur Grenzfläche 9 erstrecken, in der sie von dem Kathodenteil 5 kontaktiert werden. Die Randteile 22, 23 der n-Emitterzone 1, die mit ihrer Breite den Abstand der Halbleitergebiete 20, 21 vom Rand der Emitterzone 1 bestimmen, sind an der Grenzfläche 9 mit einer p-Dotierung versehen, so daß zwei p-leitende Kanäle 24, 25 entstehen, die die Teile 2 und 20 bzw. 2 und 21 miteinander verbinden. Die Kanäle 24, 25 können beispielsweise durch eine Implantation von Borionen erzeugt werden, die mit einer Dosis von $10^{13}/cm^2$ und einer Energie von 80 KeV eingebracht werden. Hierbei bildet der an die Enitterzone 1 angrenzende Teilbereich der p-Basis 2 das Sourcegebiet und das Gebiet 20 das Draingebiet eines MIS-Feldeffekttransistors T1', der ferner einen p-Kanal 24, eine Gateelektrode 14 und eine Gateisolierschicht 16 aufweist. Analog hierzu bilden die Teile 2, 21, 25, 15 und 17 einen zweiten Transistor T2'. Die Schaltfunktionen von T1 und T2 entsprechen den bereits anhand von Fig. 1 beschriebenen Schaltfunktionen von T1 und T2, wobei dem Anschluß G für die Dauer des Zündvorgangs ein positiver Spannungsimpuls zugeführt wird.

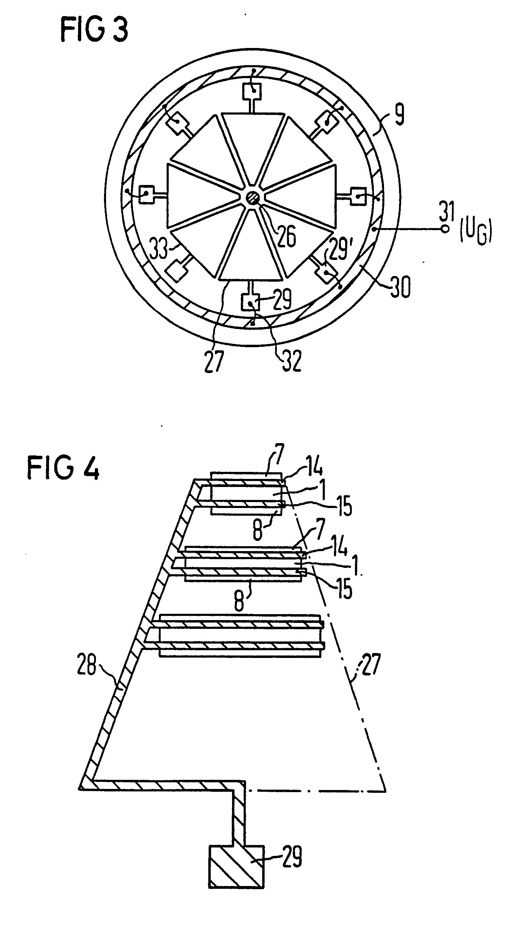

In Fig. 3 ist ein nach der Erfindung ausgebildeter Thyristor in Draufsicht datgestellt, wobei die Kathodenteile 5 aus Gründen der besseren Übersicht weggelassen wurden. Die sichtbare Grenzfläche 9, die eine runde äußere Begrenzung aufweist, wird von einer zentralen Zündelektrode 26 kontaktiert. Eine Mehrzahl von nach Fig. 1 ausgebildeten n-Emitterzonen 1 sind zu einzelnen Gruppen zusammengefaßt, die auf der Grenzfläche 9 derart angeordnet sind, daß jede von ihnen einen durch eine trapezförmige Umrandung 27 angedeuteten Bereich der p-Basis einnimmt. Figur 4 zeigt im einzelnen, wie sich eine Mehrzahl von n-Emitterzonen 1 mit den sie flankierenden n-leitenden Halbleitergebieten 7 und 8 und den zugehörigen Gateelektroden 14 und 15 auf eine durch die Umrandung 27 bestimmte Halbleiterfläche aufteilen. Dabei sind mehrere zueinander parallele Emitterzonen 1 vorgesehen, die zu den einander parallelen Seiten der Umrandung 27 parallel liegen. Die Gateelektroden 14, 15 sämtlichet zugehöriger Feldeffekttransistoren sind mit einer Leiterbahn 28 verbunden, die zu einem gemeinsamen Anschluß 29 führt. Sowohl die Leiterbahn 25 als auch der Anschluß 29 sind ebenso wie die Gateelektroden 14 durch eine Isolierschicht von der Grenzfläche 9 des Halbleiterkörpers getrennt.

Bei dem in Fig. 3 dargestellten Ausführungsbeispiel der Erfindung sind acht Gruppen von n-Emitterzonen 1 vorgesehen, die jeweils innerhalb einer solchen Umrandung 27 liegen. Diese Gruppen sind derart nebeneinander angeordnet, daß sie einen Teil der Thyristoroberfläche bedecken, der die zentrale Zündelektrode 26 umgibt und eine äußere Begrenzung nach Art eines Polygons aufweist. Außerhalb von den gemeinsamen Anschlüssen 29 sämtlicher Gruppen ist ein Sammelkontakt 30 vorgesehen, der beispeilsweise als eine ringförmige Leiterbahn realisiert ist, die gegen die p-Basis durch eine Isolierschicht, z. B. aus $SiO_2$, elektrisch isoliert ist. Der Sammelkontakt ist mit einem Anschluß 31 versehen, dem eine Gatespannung $U_G$ zugeführt wird.

Es wird nun so vorgegangen, daß der Thyristor nach der Fertigstellung der insoweit beschriebenen Struktur einer Funktionsprüfung unterzogen wird, bei der der Zündelektrode 26 ein positiver Zündstromimpuls zugeführt wird und gleichzeitig an einen der gemeinsamen Anschlüsse 29 ein negativer Spannungsimpuls $U_G$ angelegt wird. Ist die Gruppe von n-Emitterzonen, deren Emitterkurzschlüsse über diesen gemeinsamen Anschluß 29 erreichbar sind, funktionsfähig, so lassen sich die Kurzschlüsse durch den Spannungsimpuls $U_G$ unwirksam schalten, wobei der Thyristor zündet. Die erfolgte Zündung wird z. B. durch einen Spannungsmesser festgestellt, der zwischen die Anschlüsse A und K geschaltet wird, und bei gezündetem Thyristor einen wesentlich kleineren Spannungswert anzeigt als im blockierten oder gesperrten Zustand desselben. Ist die

Zündfähigkeit des Thyristors bei Ansteuerung über einen gemeinsamen Anschluß 29 festgestellt, so wird dieser Anschluß mit dem Sammelkontakt 30 über eine Verbindungsleitung 32 fest verbunden. Danach wird die Funktionsprüfung unter Zuführung eines weiteren Zündstromimpulses und eines weiteren Spannungsimpulses an einem anderen gemeinsamen Anschluß 29' wiederholt, der im Falle der Funktionsfähigkeit der über ihn erreichbaren Emitterkurzschlüsse ebenfalls mit dem Sammelkontakt 30 verbunden wird.

Nachdem sämtliche Gruppen von n-Emitterzonen 1 auf diese Weise durchgeprüft worden sind, sind alle gemeinsamen Anschlüsse 29, 29' usw., bei denen die Funktionsfähigkeit feststeht, mit 30 verbunden, während diejenigen Gruppen, die infolge einer Fehlerstelle als nicht funktionsfähig erkannt worden sind, mit dem Sammelkontakt 30 nicht verbunden sind.

In Fig. 3 wurde nur eine solche fehlerhafte Gruppe mit 33 angedeutet.

In Betrieb wird der Thyristor nach Fig. 3 zum Zünden mit einem über 26 zugeführten Zündstromimpuls und einem dem Anschluß 31 zugeführten negativen Spannungsimpuls $U_G$ beaufschlagt. Dabei zündet er im Bereich sämtlicher funktionsfähigen n-Emittergruppen, während die nicht funktionsfähigen Gruppen, z.B. 33 in Fig. 3, wegen der wirksam bleibenden Emitterkurzschlüsse nicht zum stromführenden Teil des Thyristorquerschnitts gehören. Das bedeutet aber lediglich eine geringfügige (in Fig. 3 um 1/8) verringerte Strombelastbarkeit des Thyristors, der als solcher einsatzfähig bleibt. Sind die Emitterkurzschlüsse nach Fig. 2 ausgebildet, so wird dem Anschluß 31 ein positiver Spannungsimpuls zugeführt.

Anstelle des n-Emitters kann auch der p-Emitter in einzelne p-Emitterzonen aufgeteilt sein, die von einzelnen, untereinander leitend verbundenen Teilen der Anode kontaktiert werden. Hierbei sind dann steuerbare p-Emitterkurzschlüsse vorhanden. Die Figuren können zur Darstellung dieser Variante herangezogen werden, wenn die Bezeichnung der Anschlüsse A und K miteinander vertauscht werden, die dargestellten Halbleitergebiete die jeweils entgegengesetzten Leitfähigkeiten zu den bisher beschriebenen aufweisen und die Ströme bzw. Spannungen mit jeweils entgegengesetzter Polarität zugeführt werden.

Neben der in den Figuren 3 und 4 gezeigten Konfiguration der einzelnen Emitterzonen und der Emitterzonengruppen sind beliebige andere möglich. So können beispielsweise Gruppen vorgesehen sein, die jeweils rechteckförmige Teilgebiete der an die Emitterzonen angrenzenden Basis einnehmen. Diese rechteckförmigen Teilgebiete können weiterhin nach Zeilen und Spalten ausgerichtet sein.

**Patentansprüche**

1. Thyristor mit einem Halbleiterkörper, der eine Anzahl von mit zugeordneten Kathodenteilen (5) versehenen n-Emitterzonen (1) und eine an diese angrenzende p-Basis (2) sowie einen von einer Anode (6) kontaktierten p-Emitter (4) mit einer an diesen und an die p-Basis angrenzenden n-Basis (3) aufweist, und mit an einer Grenzfläche (9) des Halbleiterkörpers angeordneten, über MIS-Feldeffekttransistoren (T1, T2) des Verarmungstyps steuerbaren Emitterkurzschlüssen, die randseitig zu den n-Emitterzonen (1) angeordnet sind, dadurch gekennzeichnet, daß die n-Emitterzonen (1) zu Gruppen (27) zusammengefaßt sind, daß die Gateanschlüsse der jeweils einet solchen Gruppe zugeordneten MIS-Feldeffekttransistoren (T1, T2) an einen gemeinsamen Anschluß (29) geführt sind, daß ein Sammelkontakt (30) vorgesehen ist, dem eine die Feldeffekttransistoren (T1, T2) steuernde Gatespannung ($U_G$) zugeführt wird, und daß die gemeinsamen Anschlüsse (29) derjenigen Gruppen von Emitterzonen, die sich einschließlich ihrer Emitterkurzschlüsse bei einer Funktionsprüfung als funktionsfähig erwiesen haben, mit dem Sammelkontakt (30) verbunden sind, während die gemeinsamen Anschlüsse derjenigen Gruppen (33) von Emitterzonen, die sich einschließlich ihrer steuerbaren Emitterkurzschlüsse bei der Funktionsprüfung als nicht funktionsfähig erwiesen haben, mit dem Sammelkontakt (30) nicht verbunden sind.

2. Thyristor mit einem Halbleiterkörper, der eine Anzahl von mit zugeordneten Anodenteilen versehenen p-Emitterzonen und eine an diese angrenzende n-Basis sowie einen von einer Kathode kontaktierten n-Emitter mit einer an diesen und an die n-Basis angrenzenden p-Basis aufweist, und mit an einer Grenzfläche des Halbleitetkörpers angeordneten, über MIS-Feldeffekttransistoren des Verarmungstyps steuerbaren Emitterkurzschlüssen, die randseitig zu den p-Emitterzonen angeordnet sind, dadurchgekennzeichnet, daß die p-Emitterzonen zu Gruppen zusammengefaßt sind, daß die Gateanschlüsse der jeweils einer solchen Gruppe zugeordneten MIS-Feldeffekttransistoren an einen gemeinsamen Anschluß geführt sind, daß ein Sammelkontakt vorgesehen ist, dem eine die Feldeffekttransistoren steuernde Gatespannung zugeführt wird, und daß die gemeinsamen Anschlüsse derjenigen Gruppen von Emitterzonen, die sich einschließlich ihrer Emitterkurzschlüsse bei einer Funktionsprüfung als funktionsfähig erwiesen haben, mit dem Sammelkontakt verbunden sind, während die gemeinsamen Anschlüsse derjenigen Gruppen von Emitterzonen, die sich einschließlich ihrer Emitterkurzschlüsse als nicht funktionsfähig erwiesen haben, mit dem Sammelkontakt nicht verbunden sind.

3. Thyristor nach Anspruch 1 oder 2, dadurch gekennzeichnet, daß die lateralen Begrenzungen (27) der einzelnen Gruppen von Emitterzonen (1) im wesentlichen trapezförmig sind und daß die einzelnen Gruppen derart nebeneinander angeordnet sind, daß sie einen Teil der Thytistoroberfläche bedecken, der eine zentrale Zündelektrode (26) umgibt.

4. Thyristor nach einem der Ansprüche 1 bis 3, dadurch gekennzeichnet, daß die Emitterzonen (1) als streifenförmige Strukturen ausgebildet sind.

5. Thyristor nach einem der Ansprüche 1 bis 4, dadurch gekennzeichnet, daß der Sammelkontakt (30) aus einer ringförmigen Leiterbahn besteht, die auf der an die Emitterzonen angrenzenden Basis (2) umfangsseitig angeordnet ist und gegen diese Basis (2) elektrisch isoliert ist.

6. Thyristot nach einem der Ansprüche 1 bis 5, dadurch gekennzeichnet, daß ein Emitterkurzschluß einen MIS-Feldeffekttransistor (T1) enthält, der aus einem Randbereich einer Emitterzone (1), aus einem in die an diese Emitterzone angrenzende Basis (2) eingefügten und mit der Basis (2) leitend verbundenen Gebiet (7), das denselben Leitfähigkeitstyp aufweist, wie die Emitterzone (1), aus einem zwischen dem Randbereich und dem Halbleitergebiet (7) liegenden Kanal (12) und aus einer diesen Kanal (12) überdeckenden und gegen den Halbleiterkörper isolierten Gateelektrode (14) besteht, die mit einem Gateanschluß (G) versehen ist.

7. Thyristor nach einem der Ansprüche 1 bis 5, dadurch gekennzeichnet, daß ein Emitterkurzschluß einen MIS-Feldeffekttransistor (T1') enthält, der aus einem in den Randbereich einer Emitterzone (1) eines ersten Leitfähigkeitstyps eingefügten Halbleitergebiet (20) des zweiten Leitfähigkeitstyps besteht, das sich bis zu einer Grenzfläche (9) des Halbleiterkörpers erstreckt und von einem Kathodenteil (5) kontaktiert wird, aus einer der Emitterzone unmittelbar benachbarten Teilbereich der an die Emitterzone (1) angrenzenden Basis (2), aus einem zwischen dem Halbleitergebiet (20) des zweiten Leitfähigkeitstyps und dem Teilbereich liegenden Kanal (24) und aus einer diesen Kanal überdeckenden und gegen den Halbleiterkörper isolierten Gateelektrode (14) besteht, die mit einem Gateanschluß (G) versehen ist.

## Claims

1. A thyristor comprising a semiconductor body which has a plurality of n-emitter zones (1), provided with allocated cathode portions (5), an adjoining p-base (2), a p-emitter (4) contacted by an anode (6), and a n-base (3) which adjoins the p-emitter and the p-base, and which body has emitter short-circuits which are arranged at a boundary surface (9) of the semiconductor body, can be controlled through MIS-field effect transistors (T1, T2) of the depletion type, and are located at the edges of the n-emitter zones (1), characterised in that the n-emitter zones (1) are combined to form groups (27); that the gate terminals of the MIS-field effect transistors (T1, T2), allocated to such a group in each case, are led to a common terminal (29); that a collective contact (30) is provided which is supplied with a gate voltage (U$_G$) which controls the field effect transistors (T1,T2); and that the common terminals (29) of those groups of emitter zones which, including their emitter short-circuits, have proved capable of functioning in an operational test, are connected to the collective contact (30), whilst the common terminals of those groups (33) of emitter zones which, including their controllable emitter short-circuits, have proved incapable of functioning in the operational test, are not connected to the collective contact (30).

2. A thyristor comprising a semiconductor body which has a plurality of p-emitter zones, provided with allocated anode portions, an adjoining n-base, an n-emitter contacted by a cathode, and a p-base which adjoins the n-emitter and the n-base, and which body has emitter short-circuits which are arranged at a boundary surface of the semiconductor body, can be controlled through MIS-field effect transistors of the depletion type, and are located at the edges of the p-emitter zones, characterised in that the p-emitter zones are combined to form groups; that the gate terminals of the MIS-field effect transistors allocated to such a group in each case are led to a common terminal; that a collective contact is provided which is supplied with a gate voltage which controls the field effect transistors; and that the common terminals of those groups of emitter zones which, including their emitter short-circuits, have proved capable of functioning in an operational test, are connected to the collective contact, whilst the common terminals of those groups of emitter zones which, including their emitter short-circuits, have proved incapable of functioning, are not connected to the collective contact.

3. A thyristor as claimed in Claim 1 or 2, characterised in that the lateral boundaries (27) of the individual groups of emitter zones (1) are basically trapezoidal in shape; and that the individual groups are arranged one beside another in such manner that they cover a part of the thyristor surface which surrounds a central firing electrode (26).

4. A thyristor as claimed in one of Claims 1 to 3, characterised in that the emitter zones (1) are in the form of strip-shaped structures.

5. A thyristor as claimed in one of Claims 1 to 4, characterised in that the collective contact (30) consists of a ring-shaped conductor path which is arranged at the periphery of the base (2) which adjoins the emitter zones and which is electrically insulated from this baae (2).

6. A thyristor as claimed in one of Claims 1 to 5, characterised in that an emitter short-circuit contains a MIS-field effect transistor (T1) which consists of an edge zone of an emitter zone (1); a zone (7) which is inserted into the base (2) adjoining this emitter zone, is conductively connected to the base (2) and has the same conductivity type as the emitter zone (1); a channel (12) located between the edge zone and the semiconductor zone (7); and a gate electrode (14) which covers this channel (12), is insulated from the semiconductor body and is provided with a gate terminal (G).

7. A thyristor as claimed in one of Claims 1 to 5, <u>characterised in</u> that an emitter short-circuit contains a MIS-field effect transistor (T1') which consists of a semiconductor zone (20) of the second conductivity type which is inserted into the edge zone of an emitter zone (1) of a first conductivity type, which extends to a boundary surface (9) of the semiconductor body and which is contacted by a cathode portion (5); a sub-zone, located directly adjacent to the emitter zone, of the base (2) adjoining the emitter zone (1); a channel (24) located between the semiconductor zone (20) of the second conductivity type and the sub-zone; and a gate electrode (14) which covers this channel, is insulated from the semiconductor body, and is provided with a gate terminal (G).

## Revendications

1. Thyristor comportant un corps semiconducteur, qui possède un nombre de zones d'émetteur (1) de type n, munies d'éléments associés de cathode (5), et une base (2) de type p, jouxtant ces zones, ainsi qu'un émetteur (4) de type p, en contact avec une anode (6), et une base (3) de type n, jouxtant cet émetteur et la zone de base de type p, et comportant das courts-circuits d'émetteur, qui sont disposés sur une surface limite (9) du corps semiconducteur, peuvent être commandés au moyen de transistors à effet de champ MIS (T1,T2) du type à appauvrissement et sont disposés sur le bord des zones d'émetteur (1) de type n, caractérisé par le fait que les zones d'émetteur (1) de type n sont réunies par groupes (27), que les bornes de grille des transistors à effet de champ MIS (T1,T2) associés respectivement à un tel groupe sont raccordées à une borne commune (29), qu'il est prévu un contact commun (30) auquel est appliquée une tension de grille (U$_G$) commandant les transistors à effet de champ (T1,T2), et que les bornes communes (29) des groupes de zones d'émetteur, qui se sont avérés être aptes à fonctionner, y compris leurs courts-circuits d'émetteur, lors d'un contrôle de fonctionnement, sont reliées au contact commun (30), tandis que les bornes communes des groupes (33) de zones d'émetteur, qui ne se se sont pas avérés aptes à fonctionner, y compris leurs courts-circuits d'émetteur commandables, lors du contrôle du fonctionnement, ne sont pas reliées au contact commun (30).

2. Thyristor comportant un corps semiconducteur, qui comporte un nombre de zones d'émetteur du type p munies d'éléments associés. d'anode et une base de type n, jouxtant ces zones, ainsi qu'un émetteur du type n, en contact avec une cathode, et une base de type p jouxtant cet émetteur et la base de type n, et comportant des courts-circuits d'émetteur, qui sont disposés au niveau d'une surface limite du corps semiconducteur, peuvent être commandés par des transistors à effet de champ MIS du type à appauvrissement et sont disposés sur le bord des zones d'émetteur de type p, caractérisé par le fait que les zones d'émetteur de type n sont réunies par groupes, que les bornes de grille des transistors à effet de champ MIS associés respectivement à un tel groupe sont raccordées à une borne commune, qu'il est prévu un contact commun auquel est appliquée une tension de grille commandant les transistors à effet de champ, et que les bornes communes des groupes de zones d'émetteur, qui se sont avérés être aptes à fonctionner, y compris leurs courts-circuits d'émetteur, lors d'un contrôle de fonctonnement, sont reliées au contact commun, tandis que les bornes communes des groupes de zones d'émetteur, qui ne se sont pas avérés aptes à fonctionner, y compris leurs courts-circuits d'émetteur commandables, lors du contrôle du fonctionnement, ne sont pas reliées au contact commun.

3. Thyristor suivant la revendication 1 ou 2, caractérisé par le fait que les limites latérales (27) des différents groupes de zones d'émetteur (1) possèdent une forme essentiellement trapézoïdale et que les différents groupes sont disposés côte-à-côte de telle sorte qu'ils recouvrent une partie de la surface du thyristor, qui entoure une électrode centrale d'amorçage (26).

4. Thyristor suivant l'une des revendications 1 à 3, caractérisé par le fait que les zones d'émetteurs (1) sont réalisées sous la forme de structures en forme de bandes.

5. Thysristor suivant l'une des revendications 1 à 4, caractérisé par le fait que le contact commun (30) est constitué par une bande conductrice annulaire, qui est disposée sur le pourtour de la zone de base (2) jouxtant les zones d'émetteur et est isolée électriquement vis-à-vis de cette base (2).

6. Thyristor suivant l'une des revendications 1 à 5, caractérisé par le fait qu'un court-circuit d'émetteur contient un transistor à effet de champ MIS (31), qui est constitué par une partie marginale d'une zone d'émetteur (1), par une région (7) insérée dans la base (2) jouxtant cette zone d'émetteur, et reliée de façon conductrice à la base (2) et qui possède le même type de conductivité que la zone d'émetteur (1), par un canal (12) situé entre la partie marginale et la région semiconductrice (7), et par une électrode de grille (14) recouvrant ce canal (12) et isolée vis-à-vis du corps semiconducteur et qui est munie d'une borne de grille (G).

7. Thyristor suivant l'une des revendications 1 à 5, caractérisé par le fait qu'un court-circuit d'émetteur contient un court-circuit à effet de champ MIS (T1'), qui est constitué par une région semiconductrice (20) possédant le second type de conductivité et insérée dans la partie marginale d'une zone d'émetteur (1) possédant un premier type de conductivité, et qui s'étend jusqu'à une surface limite (9) du corps semiconducteur et est en contact avec un élément de cathode (5) et est constituée par une région partielle, directement voisine de la zone d'émetteur, de la base (2) jouxtant la zone d'émetteur (1), par un canal (24) situé entre la région semiconductrice (20) possédant le second type de conductivité et la région partielle, et par une électrode de grille (14) recouvrant ce canal et isolée par rapport au corps semiconducteur et qui est munie d'une borne de grille (G).

# FIG 1

# FIG 2

## FIG 3

## FIG 4